# EUROPEAN PATENT APPLICATION

(11) **EP 4 686 949 A1**
(43) Date of publication of application: **04.02.2026**
(21) Application number: 24191726.9
(22) Date of filing: 30.07.2024
(51) Int. Cl.: G01R 19/25, H02J 13/00

(54) **PLACEMENT OF MEASUREMENT DEVICES FOR OBSERVABILITY OF VERY LARGE POWER SYSTEMS**

(71) Applicant: Hitachi Energy Ltd, 8050 Zürich (CH)
(72) Inventor: NUQUI, Reynaldo, Cary, NC, 27513 (US); SHCHETININ, Dmitry, 5600 Lenzburg (CH); LARSSON, Mats, 5102 Rupperswil (CH)
(74) Representative: Vossius & Partner Patentanwälte Rechtsanwälte mbB

(57) **Abstract**

Classical optimization techniques, when applied to the placement of measurement devices in very large power networks, become computationally intractable and are not guaranteed to converge. In contrast, disclosed embodiments guarantee an optimal placement strategy of measurement devices, such as phasor measurement units for measuring voltage and current, across a power network of any size, such that the voltage at each bus is observable, in dramatically less computational time than classical optimization techniques. In particular, embodiments traverse at least one spanning tree of a graph of the power network, and place measurement devices based on distance values of the nodes from the nearest measurement device. The distance values, and potentially the observability status, of all nodes are updated after each placement.

## Description

### BACKGROUND

### Field of the Invention

The embodiments described herein are generally directed to the monitoring of a power system, and, more particularly, to the placement of measurement devices for observability of very large power systems.

### Description of the Related Art

The digitalization of power systems requires an increase in the number of sensors or other measurement devices being installed. However, due to constraints in cost and available communication links, it is generally impractical for a measurement device to be placed at every bus within a power system. Thus, the operator must maximize the benefits of a finite set of measurement devices in the power system.

Ideally, the measurement devices should be placed strategically, such that the power system is fully observable. In this context, "observability" means that the state (i.e., voltage) at every bus in the power system is either directly measured by a measurement device or is calculable, in real time, from the available measurements using circuit laws, such as Kirchoff's Laws.

The placement problem for measurement devices has traditionally been solved as a combinatorial optimization problem, such as in the case of the Tabu search. While such solutions may work for small systems, these solutions break down, when applied to practical power systems that are very large, due to the curse of dimensionality. Furthermore, the requirement of observability in the placement strategy creates a bottleneck in such solutions.

R.F. Nuqui, et al., "Phasor measurement unit placement techniques for complete and incomplete observability," IEEE Transactions on Power Delivery, vol. 20, no. 4, pp. 2381-2388, October 2005, doi:10.1109/TPWRD.2005.855457, describes one approach for generating a placement strategy for measurement devices. However, the approach in Nuqui et al. still utilizes combinatorial optimization and graph theoretic methods to ensure full observability of the system.

### SUMMARY

Accordingly, systems, methods, and non-transitory computer-readable media are disclosed for the placement of measurement devices for observability of very large power systems. A first objective achievable by disclosed embodiments is the determination of an optimal placement strategy with reduced computational time and complexity. A second objective achievable by disclosed embodiments is guaranteed convergence to an optimal solution for very large power systems. A third objective achievable by disclosed embodiments is guaranteed observability of all nodes in a power network.

In an embodiment, a method comprises using at least one hardware processor to determine an optimal placement strategy, for measurement devices in a power network, that provides observability of a plurality of nodes in the power network, by: in each of one or more outer iterations, identifying a spanning tree of the power network, wherein the spanning tree comprises all of the plurality of nodes in the power network and one or more edges that each represents a connection between a pair of the plurality of nodes, in each of one or more inner iterations, generating a candidate placement strategy by selecting a start node from the plurality of nodes, traversing the spanning tree, starting from the start node, such that each of the plurality of nodes is visited at least once and a distance value is maintained for each of the plurality of nodes, wherein the distance value for each of the plurality of nodes represents a distance between that node and a measurement device, and when visiting each of the plurality of nodes for a first time, determining whether or not to place the measurement device at the node based on the distance value for the node, and when determining to place the measurement device at the node, updating the candidate placement strategy to include a placement of the measurement device at the node, and updating the distance values for the plurality of nodes (e.g., all or some subset of the plurality of nodes); and determine the optimal placement strategy from one or more candidate placement strategies generated in the one or more inner iterations of the one or more outer iterations. The measurement devices may comprise phasor measurement devices.

Each of the measurement devices may be configured to measure at least one parameter, including one or both of voltage or current, at one of the plurality of nodes in the power network. Each of the measurement devices may be configured to transmit the at least one parameter to a control system over at least one communication network.

The one or more inner iterations may be a plurality of inner iterations, such that a plurality of candidate placement strategies are generated across the plurality of inner iterations, and, in each of the plurality of inner iterations, a different start node may be selected in that inner iteration than the start node that is selected in any other ones of the plurality of inner iterations. The method may further comprise using the at least one hardware processor to select one of the plurality of candidate placement strategies, having a minimum number of the measurement devices, as the optimal placement strategy.

The one or more outer iterations may be a plurality of outer iterations, such that a plurality of candidate placement strategies are generated across the plurality of outer iterations, and, in each of the plurality of outer iterations, a different spanning tree may be identified in that outer iteration than the spanning tree that is identified in any other ones of the plurality of outer iterations. The method may further comprise using the at least one hardware processor to select one of the plurality of candidate placement strategies, having a minimum number of the measurement devices, as the optimal placement strategy.

Generating the candidate placement strategy may further comprise: while traversing the spanning tree, maintaining an observability status for each of the plurality of nodes; and when determining to place the measurement device at one of the plurality of nodes, updating the observability statuses for all of the plurality of nodes. Updating the observability statuses for all of the plurality of nodes may comprise, for each of the plurality of nodes: when the measurement device has been placed at the node, set the observability status for the node to observable; when the node is directly connected to another one of the plurality of nodes at which the measurement device has been placed, set the observability status for the node to observable; when the node is directly connected to a zero-injection node, from among the plurality of nodes, and all other ones of the plurality of nodes connected to the zero-injection node are observable, set the observability status for the node to observable; when the node is a zero-injection node and all other ones of the plurality of nodes connected to the node have an observability status of observable, set the observability status for the node to observable; and otherwise, set the observability status for the node to non-observable.

Updating the distance values for all of the plurality of nodes may comprise, for each of the plurality of nodes: when the measurement device has been placed at the node, set the distance value for the node to a first value; otherwise, when the node is directly connected to another one of the plurality of nodes at which the measurement device has been placed, set the distance value for the node to a second value that represents a greater distance than the first value; otherwise, when the node is directly connected to another one of the plurality of nodes that has a distance value that is set to the second value, set the distance value for the node to a third value that represents a greater distance than the second value; and otherwise, when the node is directly connected to another one of the plurality of nodes that has a distance value that is set to the third value, set the distance value for the node to a fourth value that represents a greater distance than the third value. Determining whether or not to place the measurement device at the node based on the distance value for the node may comprise: when the distance value for the node is less than the fourth value, determine not to place the measurement device at the node; and when the distance value for the node is equal to or greater than the fourth value, determine to place the measurement device at the node.

Generating the candidate placement strategy may further comprise, when visiting each of the plurality of nodes for the first time, flagging the node as having been visited. Generating the candidate placement strategy may further comprise, when visiting each of the plurality of nodes: determining whether or not the node has already been visited based on whether or not the node has been flagged as having been visited; and when determining that the node has already been visited, when the node is directly connected to an unvisited one of the plurality of nodes that has not been flagged as having been visited, visit the unvisited node next, when the node is not directly connected to any unvisited ones of the plurality of nodes that have not been flagged as having been visited and the node is not the start node, backtracking to one of the plurality of nodes that was visited before the node, and when the node is not directly connected to any unvisited ones of the plurality of nodes that have not been flagged as having been visited and the node is the start node, ending the traversal of the spanning tree. Generating a candidate placement strategy may further comprise ending the traversal of the spanning tree when all of the plurality of nodes have been flagged as having been visited.

Generating the candidate placement strategy may further comprise, when visiting each of the plurality of nodes: determining whether or not the node is a leaf node; and when determining that the node is a leaf node, backtracking to one of the plurality of nodes that was visited before the node.

The method may further comprise using the at least one hardware processor to, prior to determining the optimal placement strategy, receive an existing placement of one or more existing measurement devices at one or more of the plurality of nodes, wherein each candidate placement strategy is initialized to include the existing placement of the one or more existing measurement devices.

Determining the optimal placement strategy from the one or more candidate placement strategies may comprise selecting one of the one or more candidate placement strategies, having a minimum number of the measurement devices, as the optimal placement strategy.

The method may further comprise using the at least one hardware processor to transmit the optimal placement strategy to a human-to-machine interface, and/or installing physical measurement devices at locations within the power network that correspond to a subset of the plurality of nodes at which measurement devices have been placed according to the optimal placement strategy.

It should be understood that any of the features in the methods above may be implemented individually or with any subset of the other features in any combination. Thus, to the extent that the appended claims would suggest particular dependencies between features, disclosed embodiments are not limited to these particular dependencies. Rather, any of the features described herein may be combined with any other feature described herein, or implemented without any one or more other features described herein, in any combination of features whatsoever. In addition, any of the methods, described above and elsewhere herein, may be embodied, individually or in any combination, in executable software modules of a processor-based system, such as a server, and/or in executable instructions stored in a non-transitory computer-readable medium.

### BRIEF DESCRIPTION OF THE DRAWINGS

The details of the present invention, both as to its structure and operation, may be gleaned in part by study of the accompanying drawings, in which like reference numerals refer to like parts, and in which:
FIG. 1 illustrates an example infrastructure, in which any of the processes described herein may be implemented, according to an embodiment;
FIG. 2 illustrates an example processing system, by which any of the processes described herein may be executed, according to an embodiment;
FIG. 3 illustrates an example data flow for managing a target system, according to an embodiment;
FIGS. 4-6 illustrate processes for determining an optimal placement of measurement devices for observability of a target system, according to embodiments; and
FIGS. 7A-7E illustrate the operation of a process for determining an optimal placement of measurement devices for observability of a power system, according to embodiments.

### DETAILED DESCRIPTION

In an embodiment, systems, methods, and non-transitory computer-readable media are disclosed for the placement of measurement devices for observability of very large power systems. After reading this description, it will become apparent to one skilled in the art how to implement the invention in various alternative embodiments and alternative applications. However, although various embodiments of the present invention will be described herein, it is understood that these embodiments are presented by way of example and illustration only, and not limitation. As such, this detailed description of various embodiments should not be construed to limit the scope or breadth of the present invention as set forth in the appended claims.

### 1. Infrastructure

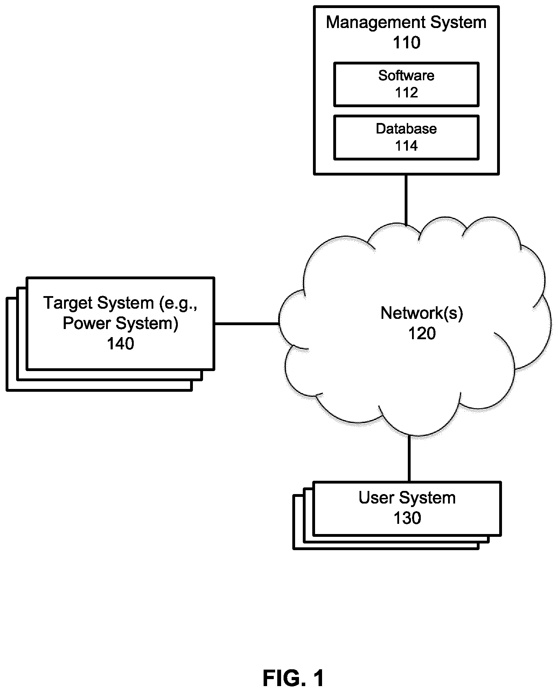

FIG. 1 illustrates an example infrastructure in which any of the disclosed processes may be implemented, according to an embodiment. The infrastructure may comprise a management system 110 (e.g., comprising one or more servers) that hosts and/or executes one or more of the various processes described herein, which may be implemented in software and/or hardware. Examples of management system 110 include, without limitation, a supervisory control and data acquisition (SCADA) system, a power management system (PMS), an energy management system (EMS), a distribution management system (DMS), an advanced DMS (ADMS), and the like. Alternatively, management system 110 may be a platform that comprises tools to facilitate the management of a system, without providing functionality for actual management of the system. In any case, management system 110 may comprise dedicated servers, or may instead be implemented in a computing cloud, in which the computational resources of one or more servers are dynamically and elastically allocated to multiple tenants based on demand. The servers may be collocated (e.g., in a single data center) and/or geographically distributed (e.g., across a plurality of data centers). Management system 110 may also comprise or be communicatively connected to software 112 and/or a database 114. In addition, management system 110 may be communicatively connected to one or more user systems 130 and/or target systems 140 via one or more networks 120.

Network(s) 120 may comprise the Internet, and management system 110 may communicate with user system(s) 130 and/or target system(s) 140 through the Internet using standard transmission protocols, such as HyperText Transfer Protocol (HTTP), HTTP Secure (HTTPS), File Transfer Protocol (FTP), FTP Secure (FTPS), Secure Shell FTP (SFTP), eXtensible Messaging and Presence Protocol (XMPP), Open Field Message Bus (OpenFMB), IEEE Smart Energy Profile Application Protocol (IEEE 2030.5), Internet Control Center Communications Protocol (ICCP) International Electrotechnical Commission (IEC) 61850, and the like, as well as proprietary protocols. While management system 110 is illustrated as being connected to various systems through a single set of network(s) 120, it should be understood that management system 110 may be connected to the various systems via different sets of one or more networks. For example, management system 110 may be connected to a subset of user systems 130 and/or target systems 140 via the Internet, but may be connected to one or more other user systems 130 and/or target systems 140 via an intranet. Furthermore, while only a few user systems 130 and target systems 140, one instance of software 112, and one database 114 are illustrated, it should be understood that the infrastructure may comprise any number of user systems, target systems, software instances, and databases.

User system(s) 130 may comprise any type or types of computing devices capable of wired and/or wireless communication, including without limitation, desktop computers, laptop computers, tablet computers, smart phones or other mobile phones, servers, game consoles, televisions, set-top boxes, electronic kiosks, point-of-sale terminals, embedded controllers, programmable logic controllers (PLCs), and/or the like. However, it is generally contemplated that user system(s) 130 would comprise personal computers, mobile devices, or workstations by which agents of an operator of a target system 140 can interact with management system 110. These interactions may comprise inputting data (e.g., parameters for configuring the processes described herein) and/or receiving data (e.g., the outputs of processes described herein) via a graphical user interface provided by management system 110 or a system between management system 110 and user system(s) 130. The graphical user interface may comprise screens (e.g., webpages) that include a combination of content and elements, such as text, images, videos, animations, references (e.g., hyperlinks), frames, inputs (e.g., textboxes, text areas, checkboxes, radio buttons, drop-down menus, buttons, forms, etc.), scripts (e.g., JavaScript), and the like, including elements comprising or derived from data stored in database 114.

Target system 140 may comprise any type of system for which data are measured via physical measurement devices. However, in the context of specific, non-limiting examples that are provided throughout the present disclosure, it will be assumed that target system 140 comprises or consists of a power system, such as a power network. A power system may comprise one or more, and generally a plurality of, power resources connected in a network, which may comprise a power distribution network, a power transmission network, and/or the like. The power resources may comprise power generators, energy storage systems, loads (e.g., rechargeable energy storage system or other controllable load, non-controllable load, etc.), and/or the like. The power generators may comprise different types of power generators, such as thermal power plants (e.g., coal, natural gas, nuclear, geothermal, etc.), hydroelectric power plants, renewable resource power plants (e.g., solar, wind, geothermal, etc.), and/or the like.

Management system 110 may execute software 112, comprising one or more software modules that implement one or more of the disclosed processes. In addition, management system 110 may comprise, be communicatively coupled with, or otherwise have access to database 114 that stores the data input into and/or output from one or more of the disclosed processes. Any suitable database may be utilized in database 114, including without limitation MySQL^{™}, Oracle^{™}, IBM^{™}, Microsoft SQL^{™}, Access^{™}, PostgreSQL^{™}, MongoDB^{™}, and/or the like, and including cloud-based databases, proprietary databases, and unstructured databases.

### 2. Example Processing Device

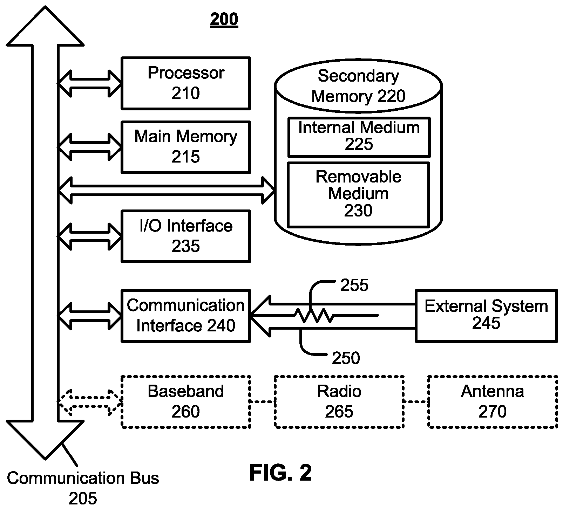

FIG. 2 is a block diagram illustrating an example wired or wireless system 200 that may be used in connection with various embodiments described herein. For example, system 200 may be used as or in conjunction with one or more of the functions, methods, or other processes (e.g., to store and/or execute software 112) described herein, and may represent components of management system 110, user system(s) 130, target system(s) 140, and/or other processing devices described herein. System 200 can be a server or any conventional personal computer, or any other processor-enabled device that is capable of wired or wireless data communication. Other computer systems and/or architectures may be also used, as will be clear to those skilled in the art.

System 200 preferably includes one or more processors 210. Processor(s) 210 may comprise a central processing unit (CPU). Additional processors may be provided, such as a graphics processing unit (GPU), an auxiliary processor to manage input/output, an auxiliary processor to perform floating-point mathematical operations, a special-purpose microprocessor having an architecture suitable for fast execution of signal-processing algorithms (e.g., digital-signal processor), a processor subordinate to the main processor (e.g., back-end processor), an additional microprocessor or controller for dual or multiple processor systems, and/or a coprocessor. Such auxiliary processors may be discrete processors or may be integrated with a main processor 210. Examples of processors which may be used with system 200 include, without limitation, any of the processors (e.g., Pentium^{™}, Core i7^{™}, Xeon^{™}, etc.) available from Intel Corporation of Santa Clara, California, any of the processors available from Advanced Micro Devices, Incorporated (AMD) of Santa Clara, California, any of the processors (e.g., A series, M series, etc.) available from Apple Inc. of Cupertino, any of the processors (e.g., Exynos^{™}) available from Samsung Electronics Co., Ltd., of Seoul, South Korea, and/or the like.

Processor 210 is preferably connected to a communication bus 205. Communication bus 205 may include a data channel for facilitating information transfer between storage and other peripheral components of system 200. Furthermore, communication bus 205 may provide a set of signals used for communication with processor 210, including a data bus, address bus, and/or control bus (not shown). Communication bus 205 may comprise any standard or non-standard bus architecture such as, for example, bus architectures compliant with industry standard architecture (ISA), extended industry standard architecture (EISA), Micro Channel Architecture (MCA), peripheral component interconnect (PCI) local bus, standards promulgated by the Institute of Electrical and Electronics Engineers (IEEE) including IEEE 488 general-purpose interface bus (GPIB), IEEE 696/S-100, and/or the like.

System 200 may comprise a main memory 215. Main memory 215 provides storage of instructions and data for programs executing on processor 210, such as one or more of the processes discussed herein (e.g., embodied in software 112). It should be understood that programs stored in the memory and executed by processor 210 may be written and/or compiled according to any suitable language, including without limitation C/C++, Java, JavaScript, Perl, Visual Basic, .NET, and the like. Main memory 215 is typically semiconductor-based memory such as dynamic random access memory (DRAM) and/or static random access memory (SRAM). Other semiconductor-based memory types include, for example, synchronous dynamic random access memory (SDRAM), Rambus dynamic random access memory (RDRAM), ferroelectric random access memory (FRAM), and the like, including read only memory (ROM).

System 200 may also comprise a secondary memory 220. Secondary memory 220 may optionally include an internal medium 225 and/or a removable medium 230. Internal medium 225 may comprise, for example, a hard disk drive (HDD), a solid state drive (SSD), and/or the like. Removable medium 230 may comprise, for example, a magnetic tape drive, a compact disc (CD) drive, a digital versatile disc (DVD) drive, a flash memory drive, and/or the like. Secondary memory 220 is a non-transitory computer-readable medium having computer-executable code (e.g., software 112) and/or other data stored thereon. The computer software or data stored on secondary memory 220 is read into main memory 215 for execution by processor 210.

System 200 may comprise an input/output (I/O) interface 235. I/O interface 235 provides an interface between one or more components of system 200 and one or more input and/or output devices. Example input devices include, without limitation, sensors, keyboards, touch screens or other touch-sensitive devices, cameras, biometric sensing devices, computer mice, trackballs, pen-based pointing devices, and/or the like. Examples of output devices include, without limitation, other processing devices, cathode ray tubes (CRTs), plasma displays, light-emitting diode (LED) displays, liquid crystal displays (LCDs), printers, vacuum fluorescent displays (VFDs), surface-conduction electron-emitter displays (SEDs), field emission displays (FEDs), and/or the like. In some cases, an input and output device may be combined, such as in the case of a touch-panel display (e.g., in a smartphone, tablet, or other mobile device).

System 200 may comprise a communication interface 240. Communication interface 240 allows software and other data to be transferred between system 200 and external devices, networks, or other external systems 245. For example, data, which may include computer software or executable code, may be transferred to system 200 from external system 245 (e.g., a network server) and/or from system 200 to external system 245, via communication interface 240. Examples of communication interface 240 include a built-in network adapter, network interface card (NIC), Personal Computer Memory Card International Association (PCMCIA) network card, card bus network adapter, wireless network adapter, Universal Serial Bus (USB) network adapter, modem, a wireless data card, a communications port, an infrared interface, an IEEE 1394 fire-wire, and any other device capable of interfacing system 200 with a network (e.g., network(s) 120) or another computing device. Communication interface 240 preferably implements industry-promulgated protocol standards, such as Ethernet IEEE 802 standards, Fiber Channel, digital subscriber line (DSL), asynchronous digital subscriber line (ADSL), frame relay, asynchronous transfer mode (ATM), integrated digital services network (ISDN), personal communications services (PCS), transmission control protocol/Internet protocol (TCP/IP), serial line Internet protocol/point to point protocol (SLIP/PPP), and so on, but may also implement customized or non-standard interface protocols as well.

Data transferred via communication interface 240 are generally in the form of electrical communication signals 255. These signals 255 may be provided to communication interface 240 via a communication channel 250. In an embodiment, communication channel 250 may be a wired or wireless network (e.g., network(s) 120), or any variety of other communication links. Communication channel 250 carries signals 255 and can be implemented using a variety of wired or wireless communication means including wire or cable, fiber optics, conventional phone line, cellular phone link, wireless data communication link, radio frequency ("RF") link, or infrared link, just to name a few.

Computer-executable code (e.g., computer programs, such as software 112) is stored in main memory 215 and/or secondary memory 220. Computer programs can also be received via communication interface 240 and stored in main memory 215 and/or secondary memory 220. Such computer programs, when executed, enable system 200 to perform one or more of the processes described elsewhere herein.

In this description, the term "computer-readable medium" is used to refer to any non-transitory computer-readable storage media used to provide computer-executable code and/or other data to or within system 200. Examples of such media include main memory 215, secondary memory 220 (including internal memory 225 and/or removable medium 230), and any peripheral device communicatively coupled with communication interface 240, such as external system 245 (e.g., a network information server or other network device). These non-transitory computer-readable media are means for providing executable code, programming instructions, software, and/or other data to processor(s) 210.

System 200 may also include optional wireless communication components that facilitate wireless communication over a voice network and/or a data network (e.g., in the case of user system 130 that is a smart phone or other mobile device). The wireless communication components comprise an antenna system 270, a radio system 265, and a baseband system 260. In system 200, radio frequency (RF) signals are transmitted and received over the air by antenna system 270 under the management of radio system 265.

In an embodiment, antenna system 270 may comprise one or more antennae and one or more multiplexors (not shown) that perform a switching function to provide antenna system 270 with transmit and receive signal paths. In the receive path, received RF signals can be coupled from a multiplexor to a low noise amplifier (not shown) that amplifies the received RF signal and sends the amplified signal to radio system 265.

In an alternative embodiment, radio system 265 may comprise one or more radios that are configured to communicate over various frequencies. In an embodiment, radio system 265 may combine a demodulator (not shown) and modulator (not shown) in one integrated circuit (IC). The demodulator and modulator can also be separate components. In the incoming path, the demodulator strips away the RF carrier signal leaving a baseband receive signal, which is sent from radio system 265 to baseband system 260.

Baseband system 260 is also communicatively coupled with processor(s) 210, which may have access to data storage areas 215 and 220. Thus, data, including computer programs, can be received from baseband processor 260 and stored in main memory 210 or in secondary memory 220, or executed upon receipt. Such computer programs, when executed, may enable system 200 to perform one or more of the disclosed processes.

### 3. Example Data Flow for Target System Management

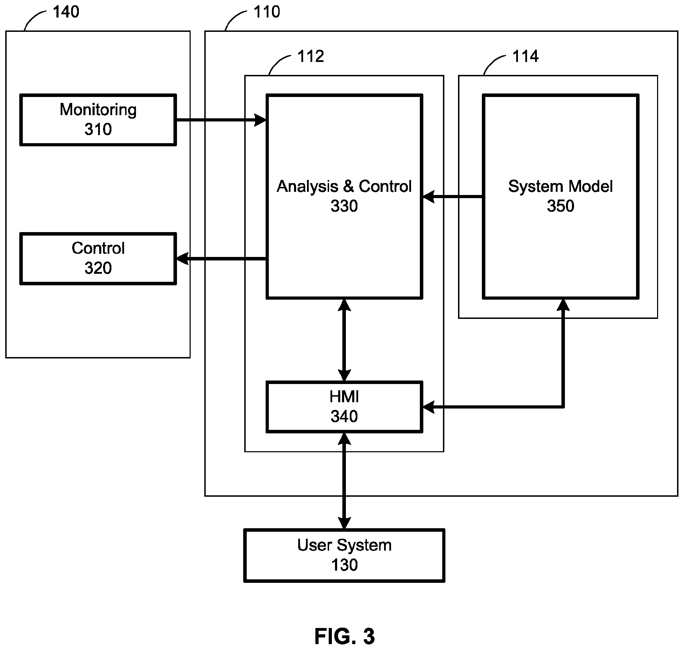

FIG. 3 illustrates an example data flow between a management system 110, a user system 130, and a target system 140, according to an embodiment. Target system 140 may comprise a monitoring module 310 and a control module 320. Software 112 of management system 110 may comprise an analysis and control module 330, and a human-to-machine interface (HMI) 340. Database 114 of management system 110 may store a system model 350. It should be understood that communications between the various systems may be performed via network(s) 120. In addition, communications between a pair of modules may be performed via an application programming interface (API) provided by one of the modules or by other inter-process communication means.

Monitoring module 310 may monitor and collect data that are output by one or more sensors in target system 140 (e.g., sensors in a power network), such as the measurement devices (e.g., phasor measurement units) described herein, whose placement within target system 140 may be determined by disclosed embodiments. Monitoring module 310 may also derive data from the collected data. Monitoring module 310 may transmit or "push" the collected and/or derived data as system telemetry to analysis and control module 330 (e.g., via an API of analysis and control module 330). Alternatively, analysis and control module 330 may retrieve or "pull" the system telemetry from monitoring module 310 (e.g., via an API of monitoring module 310). The system telemetry may include measurements at each of one or more nodes (e.g., buses within a power network) or other points within a network of target system 140. The system telemetry may be communicated from monitoring module 310 to analysis and control module 330 in real time, as data are collected and/or derived, or periodically. As used herein, the term "real time" includes events that occur simultaneously, as well as events that are separated in time by ordinary delays resulting from latencies in processing, memory access, communications, and/or the like.

Analysis and control module 330 may receive the system telemetry from monitoring module 310, and use the system telemetry in conjunction with system model 350 to determine a configuration for target system 140 (e.g., the configuration of one or more resources in a power system according to a linear state estimation), and then control target system 140 to transition to the determined configuration. In particular, analysis and control module 330 may generate control signals that are transmitted to control module 320 of target system 140. For example, the control signals may be sent via an API of control module 320. The control signals may be communicated from analysis and control module 330 of management system 110 to control module 320 of target system 140 in real time, as the system telemetry is received and analyzed, periodically (e.g., in advance of a sliding time window), or in response to a user operation. Analysis and control module 330 may control target system 140 automatically (e.g., without any user intervention), semi-automatically (e.g., requiring user approval or confirmation), and/or in response to manual user inputs.

Analysis and control module 330 may perform one or more types of analysis, such as power-flow analysis, linear state estimation, optimal power flow, distributed energy resource (DER) management, situational awareness about the network, contingency analysis, security analysis, Volt-Var optimization, loadability analysis, and/or the like. The analysis may be performed in response to a user operation, or automatically in real time or periodically. In some cases, the analysis may be provided to a user via human-to-machine interface 340. In other cases, analysis and control module 330 may, automatically (i.e., without user intervention) or semi-automatically (e.g., with user approval or confirmation), initiate a control operation based on the analysis. Initiation of the control operation may comprise transmitting control commands to control module 320 of target system 140, which may responsively control target system 140 according to the control commands.

Control module 320 of target system 140 may receive the control signals from analysis and control module 330, and control one or more components of target system 140 in accordance with the control signals. Examples of such control include, in the context of a power system, setting a setpoint (e.g., active and/or reactive power for power generators, voltage, etc.), adjusting the power output of a power generator, adjusting the charging or discharging of an energy storage system, adjusting the power input to a load, closing or opening a switch (e.g., circuit breaker), and/or the like.

Human-to-machine interface 340 may generate a graphical user interface that is transmitted to user system 130 and receive inputs to the graphical user interface via user system 130. The graphical user interface may provide information regarding the current state of target system 140 determined from the system telemetry, a predicted state of target system 140 determined by analysis and control module 330, a configuration of target system 140 determined by analysis and control module 330, a control decision or recommendation for target system 140 determined by analysis and control module 330, a visual representation of system model 350, and/or the like. Of particular relevance to disclosed embodiments, the graphical user interface may provide a representation of a placement strategy for measurement devices within target system 140. In addition, the graphical user interface may provide inputs that enable a user of user system 130 to configure settings of analysis and control module 330, configure system model 350, specify or approve controls to be transmitted to control module 320 of target system 140, analyze target system 140, and/or the like.

System model 350 may be stored in database 114 and accessed by modules, such as analysis and control module 330, via any known means (e.g., via an API of database 114, a direct query of database 114, etc.). Database 114 may store a system model 350 for each target system 140 that is managed by management system 110. Each system model 350 may model target system 140 in any suitable manner. For example, system model 350 may comprise a single-line diagram representing the components of the network (e.g., nodes in a graph representation) and their relationships to each other (e.g., edges in a graph representation), a system of equations, and/or the like. It should be understood that system model 350 may be implemented as a data structure that is capable of being automatically analyzed by software modules, including analysis and control module 330. Of particular relevance to disclosed embodiments, system model 350 may comprise a representation of each target system 140 as a graph, which includes a plurality of nodes (e.g., representing buses) and one or more edges (e.g., representing branches or other electrical lines) connecting pairs of nodes.

### 4. Determination of Optimal Placement Strategy

At a high level, disclosed embodiments determine an optimal placement strategy for measurement devices in a target system 140, such as a power network. In an embodiment, the optimal placement strategy minimizes the number of measurement devices while ensuring observability of at least a subset, and preferably all, of the nodes in target system 140.

A measurement device may be any physical device that is configured to measure at least one parameter of target system 140. In the context of a power network, the parameter(s) may include voltage and/or current at a node within the power network. Each measurement device may be configured to transmit the parameter(s) to a control system (e.g., analysis and control module 330, via monitoring module 310) over at least one communication network (e.g., network(s) 120).

For example, the measurement device may comprise or consist of a phasor measurement unit (PMU). A phasor measurement unit measures both voltage and current in real time. Phasor measurement units can collect these measurements at speeds of up to 16.67 milliseconds in a 60 Hertz system. This enables a very high sampling rate, which in turn, enables advanced monitoring and control of the power network. Phasor measurement units may be time-synchronized with a Global Navigation Satellite System (GNSS), such as the Global Positioning System (GPS), such that measurements from different phasor measurement units can be temporally correlated with each other. In addition to measuring voltage and current, phasor measurement units are able to communicate the digital status of equipment, such as circuit breakers (e.g., open or closed).

In an embodiment, the placement problem for measurement devices is concerned with determining the minimum number of measurement devices and their locations within target system 140, such that the state (e.g., voltage and/or current) of every node in target system 140 is observable. Mathematically, this placement problem is to find a placement strategy S* with the minimum number of placements: 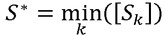 wherein *Sₖ* is a candidate placement strategy, each of *S** and *Sₖ* may comprise or consist of a vector representing a subset of nodes, in the graph of target system 140, at which measurement devices are placed according to the respective placement strategy, mine(·) is a function that finds the minimum of its inputs, and [·] is the 1-norm for a vector.

In an embodiment, the placement problem is subject to the constraint that target system 140 is observable. Mathematically, target system 140 is observable if the B matrix below is full rank: 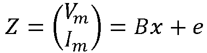 wherein Z comprises a vector of measured voltages *Vₘ* and a vector of measured currents *Iₘ* in target system 140, *x* is the state vector for nodes in target system 140, *B* is the measurement matrix that maps state vector x to the expected measured value, and e is an error.

Target system 140 may be represented as a graph *G* (e.g., in system model 350) with vertices V, also referred to herein as "nodes," and edge(s) E. Each edge E is terminated on its two ends by a vertex V. In terms of graph theory, a graph *G*(*V, E*) is observable if the placement strategy *S** results in the state of each edge E being observed. In the context of a power network, the vertices V may be buses, and the edges E may be electrical lines. In this case, an edge E is observable if the current on that edge E is either directly measured or calculable from voltages at each vertex V at the ends of that edge E.

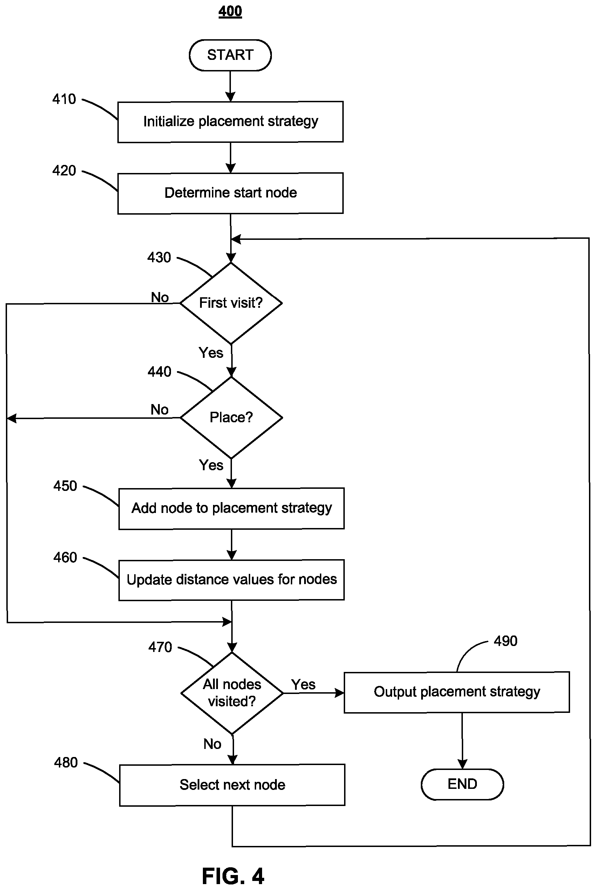

FIG. 4 illustrates a process 400 for determining an optimal placement of measurement devices for observability of a target system 140 (e.g., power network), according to an embodiment. Process 400 may be implemented by software 112 on management system 110, for example, within analysis and control module 330 of software 112. While process 400 is illustrated with a certain arrangement and ordering of subprocesses, process 400 may be implemented with fewer, more, or different subprocesses and a different arrangement and/or ordering of subprocesses. In addition, it should be understood that any subprocess, which does not depend on the completion of another subprocess, may be executed before, after, or in parallel with that other independent subprocess, even if the subprocesses are described or illustrated in a particular order.

Process 400 traverses a spanning tree of a graph of target system 140. As described above, the graph may comprise a plurality of vertices or "nodes" that are connected to each other, in a network, by at least one and generally a plurality of edges. In the context of a power system, and particularly, a power network (e.g., power distribution network or power transmission network), the vertices represent buses and the edges represent electrical lines. As is well-known in the art, a spanning tree is a subgraph of the graph, which is a tree that includes all of the vertices of the graph and a sufficient set of edges such that all of the vertices are connected, either directly or indirectly, to each other without any loops. The spanning tree may or may not include all of the edges of the graph, but, in very dense graphs, will generally consist of a small subset of the edges of the graph. In particular, the spanning tree will generally include a number of edges that is one less than the number of vertices. The spanning tree of the graph of target system 140 may be determined according to any suitable pathfinding algorithm. Examples of suitable pathfinding algorithms include, without limitation, Dijkstra's algorithm, the A* search algorithm, and/or the like. In any case, a spanning tree, comprising all of the plurality of nodes (e.g., buses) in target system 140 (e.g., power network) and one or more edges, each representing a connection (e.g., branch) between a pair of the plurality of nodes in target system 140, is identified for process 400.

Subprocess 410 may initialize a new placement strategy. In particular, the placement strategy may comprise a data structure that represents a vector or other list of nodes, within target system 140, at which measurement devices are to be placed. In the context of a power network, each of these nodes may represent a bus, and each measurement device may comprises a phasor measurement unit. Initially, the data structure may be empty, in which case subprocess 410 comprises generating a new empty data structure.

Alternatively, target system 140 may have an existing placement of measurement devices. In this case, an existing placement, of one or more existing measurement devices at one or more of the plurality of nodes in target system 140, may be received. Subprocess 410 may comprise generating a new data structure that comprises an identifier of each node at which a measurement device has already been placed within target system 140, according to the existing placement. In other words, the placement strategy may be initialized to include the existing placement of existing measurement device(s). The effect of this is that the final placement strategy will respect these incumbent placement(s).

Process 400, while traversing the spanning tree, may also maintain one or more other data structures, which may be initialized in subprocess 410. In particular, a distance value may be maintained for each of the plurality of nodes in target system 140. The distance value for each of the plurality of nodes may represent a distance between that node and a measurement device, and particularly, a distance between the node and the nearest node at which a measurement device has been placed. In an embodiment, the distance value is a conceptual distance, represented, for example, as the number of edges between two nodes (e.g., the node under consideration and the nearest node at which a measurement device has been placed). In the event that the placement strategy is initially empty, the distance value for each of the plurality of nodes may be initialized to a very large number (e.g., practical infinity) or any number that is guaranteed to be larger than any distance between nodes (e.g., greater than the number of edges in the graph). In an embodiment in which there is an existing placement of measurement devices, such that the placement strategy is not initially empty, the initial distance values may be initialized according to the existing placement of measurement devices, as will be described below with respect to subprocess 460.

In addition to the distance values, an observability status may be maintained for each of the plurality of nodes in target system 140. The observability status may be a binary value that indicates that either the node is observable (e.g., the voltage and/or current are measured or calculable from the measurement(s) at one or more other nodes) or is not observable (e.g., the voltage and/or current is not measured and is not calculable from the measurements at other nodes). In the event that the placement strategy is initially empty, the observability status for each of the plurality of nodes may be initialized to non-observable. In an embodiment in which there is an existing placement of measurement devices, such that the placement strategy is not initially empty, the initial observability statuses may be initialized according to the existing placement of measurement devices, as will be described below with respect to subprocess 460.

Subprocess 420 may determine a start node. In particular, a start node may be selected from the plurality of nodes in the spanning tree being traversed, according to any suitable selection mechanism. For example, the selection mechanism may be a random selection of the start node. In a preferred embodiment, the selection mechanism attempts to select a non-leaf node as the start node, if possible. For instance, the selection mechanism could randomly select a non-leaf node. However, in a more preferred embodiment, the selection mechanism selects a non-leaf node that is directly connected (i.e., "incident") to a leaf node and has the maximum number of edges. If two or more such non-leaf nodes exist, the start node may be randomly selected from this set of non-leaf nodes. Advantageously, by selecting a non-leaf node, which is incident to a leaf node and with a maximum number of edges, as the start node, the placement of a measurement device at the start node will add observability for a maximum number of nodes. Regardless of how the start node is determined, the spanning tree is traversed, starting from the start node, such that each of the plurality of nodes in target system 140 is visited at least once.

Subprocess 430 may determine whether or not this is the first visit to the current node under consideration based, for example, on whether or not the current node has been flagged as having been visited. In particular, process 400 may maintain a list of all visited nodes. The list may initially be empty, and each time a new node is visited, an identifier of that node may be added to the list to thereby flag that node as having been visited. In this case, subprocess 430 may determine that this is the first visit to the current node whenever the identifier of the current node is not already in the list (i.e., the current node has not been flagged as previously visited), and determine that this is not the first visit to the current node whenever the identifier of the current node is in the list (i.e., the current node has been flagged as previously visited). When determining that this is the first visit to the current node (i.e., "Yes" in subprocess 430), subprocess 430 may flag the current node as having been visited by adding an identifier of the current node to the list of visited nodes, and process 400 may proceed to subprocess 440. Otherwise, when determining that this is not the first visit to the current node (i.e., "No" in subprocess 430), process 400 may proceed to subprocess 470.

Subprocess 440 may determine whether or not to place a measurement device at the current node under consideration based on the distance value for the current node. In particular, when the distance value for the current node indicates that the current node is at least a predefined distance from the nearest measurement unit, subprocess 440 may determine to place a measurement device at the current node. This predefined distance may be represented as a threshold distance value, such that, when the distance value of the current node is equal to or greater than the threshold distance value, subprocess 440 determines to place a measurement device at the current node, and when the distance value of the current node is less than the threshold distance value, subprocess 440 does not determine to place a measurement device at the current node. In an exemplary embodiment described herein, this threshold distance value is three. It should be understood that, if no measurement devices have yet been placed at any nodes in target system 140, the distance value for the current node will be the initial value (e.g., a very large number), which will always be greater than the threshold distance value. When determining to place a measurement device at the current node (i.e., "Yes" in subprocess 440), process 400 may proceed to subprocess 450. Otherwise, when not determining to place a measurement device at the current node (i.e., "No" in subprocess 440), process 400 may proceed to subprocess 470.

Subprocess 450 may add the current node under consideration to the placement strategy. In other words, the placement strategy is updated to include a placement of a measurement device at the current node. In particular, an identifier of the current node is added to the data structure representing the placement strategy.

In subprocess 460, process 400 may update the distance values for all of the plurality of nodes in target system 140. The distance values may be updated according to any mechanism that represents the distance between a node and the nearest node at which a measurement device has been placed, if any. However, in a particular embodiment, subprocess 460 updates the distance values for all of the plurality of nodes by, for each of the plurality of nodes:
(1) When a measurement device has been placed at the node, setting the distance value for the node to a first value (e.g., zero);
(2) Otherwise, when the node is directly connected to another node at which a measurement device has been placed, setting the distance value for the node to a second value (e.g., one) that represents a greater distance than the first value (e.g., zero);
(3) Otherwise, when the node is directly connected to another node that has a distance value that is set to the second value (e.g., one), setting the distance value for the node to a third value (e.g., two) that represents a greater distance than the second value (e.g., one); and
(4) Otherwise, when the node is directly connected to another node that has a distance value that is set to the third value (e.g., two), setting the distance value for the node to a fourth value (e.g., three) that represents a greater distance than the third value (e.g., two).

The above Rules (1)-(4) may be referred to herein as the "distance rules." It should be understood that the distance value could take on greater values than the fourth value, by chaining additional rules that are similar to Rule (4) onto the distance rules. However, in an embodiment that is constrained by an observability requirement, there is no need to calculate the distance beyond the fourth value. Notably, in the event that a node could be assigned more than one distance value (i.e., more than one of the distance rules applies), that node is assigned the minimum distance value that it can be assigned.

In the above embodiment of the distance rules, the fourth value (e.g., three) may be set as the threshold distance value that is used to determine whether or not to place a measurement device at the current node under consideration in subprocess 440. In other words, when the distance value of the current node is less than the fourth value, subprocess 440 does not determine to place a measurement device at the current node (i.e., "No" in subprocess 440). Conversely, when the distance value of the current node is equal to or greater than the fourth value, subprocess 440 determines to place a measurement device at the current node (i.e., "Yes" in subprocess 440).

In an embodiment that maintains the observability status, process 400 may, when determining to place a measurement device at the current node under consideration, update the observability status for all of the plurality of nodes in target system 140. The observability statuses may be updated according to any mechanism that determines whether or not a node is observable, given the placement of measurement devices in the current placement strategy. In an embodiment, subprocess 460 updates the observability statuses, in addition to the distance values, for all of the plurality of nodes, by, for each of the plurality of nodes:
(1) When a measurement device has been placed at the node, setting the observability status for the node to observable;
(2) When the node is directly connected to another node at which a measurement device has been placed, setting the observability status for the node to observable;
(3) When the node is directly connected to a zero-injection node and all other nodes connected to the zero-injection node are observable, setting the observability status for the node to observable;
(4) When the node is a zero-injection node and all other nodes connected to the node have an observability status of observable, setting the observability status for the node to observable; and
(5) Otherwise, setting the observability status for the node to non-observable.

The above Rules (1)-(5) may be referred to herein as the "observability rules." A zero-injection node may be defined as a physical bus in the power network that does not have any power generation or load. In other words, a zero-injection node neither injects power into the power network nor consumes power from the power network. As a result, when the voltages of all of the nodes that are directly connected or "incident" to the zero-injection node are known, the voltage of the zero-injection node can be calculated based on Kirchhoff's Laws.

Subprocess 470 may determine whether or not all of the plurality of nodes in target system 140 have been visited. As discussed elsewhere herein, process 400 may maintain a list of all visited nodes. Inclusion of a node in this list flags that node as having been visited, and exclusion of a node from this list flags that node as not having been visited. Subprocess 470 may determine that all of the nodes have been visited when the list of visited nodes includes all of the nodes in target system 140 (i.e., all nodes have been flagged as visited), and determine that not all of the nodes have been visited when the list of visited nodes does not include all of the nodes in target system 140 (i.e., all nodes have not been flagged as visited). When determining that not all of the nodes have been visited (i.e., "No" in subprocess 470), process 400 may proceed to subprocess 480. Otherwise, when determining that all of the nodes have been visited (i.e., "Yes" in subprocess 470), process 400 may proceed to subprocess 490. In other words, process 400 traverses the spanning tree until all of the nodes have been flagged as having been visited.

Subprocess 480 may select the next node to visit. Subprocess 480 may select the next node according to any suitable selection mechanism (e.g., depth-first search strategy). In an embodiment, when the current node is directly connected (i.e., incident) to an unvisited node (i.e., a node which has not been flagged as having been visited), the unvisited node is selected as the next node to visit. If the current node is connected to a plurality of unvisited nodes, subprocess 480 may select the next node to visit from the plurality of unvisited nodes using any suitable selection mechanism, including potentially the same or similar selection mechanism as used to select the start node in subprocess 420. In an embodiment, when the current node is not directly connected to any unvisited nodes and the current node is not the start node that was determined in subprocess 420, subprocess 480 may select the node that was visited before the current node. In this case, process 400 backtracks to the node that was visited before the current node. Notably, in the case that the current node is not directly connected to any unvisited nodes and the current node is the start node that was determined in subprocess 420, all nodes in the spanning tree will have been visited. Thus, in this case, subprocess 470 would have proceeded to subprocess 490, instead of proceeding to subprocess 480, thereby ending traversal of the spanning tree. In addition, in the case that the current node is a leaf node (i.e., only one direct connection), subprocess 480 may explicitly or implicitly determine that the current node is a leaf node, and backtrack to the node that was visited before the current node.

Subprocess 490 may output the placement strategy, produced by the foregoing traversal of the spanning tree. In an embodiment that executes a plurality of iterations of process 400, as described elsewhere herein, the output placement strategy represents one candidate placement strategy, which may or may not be ultimately selected as a final and optimal placement strategy. Otherwise, in an embodiment that executes only a single iteration of process 400, the output placement strategy may represent the final and optimal placement strategy.

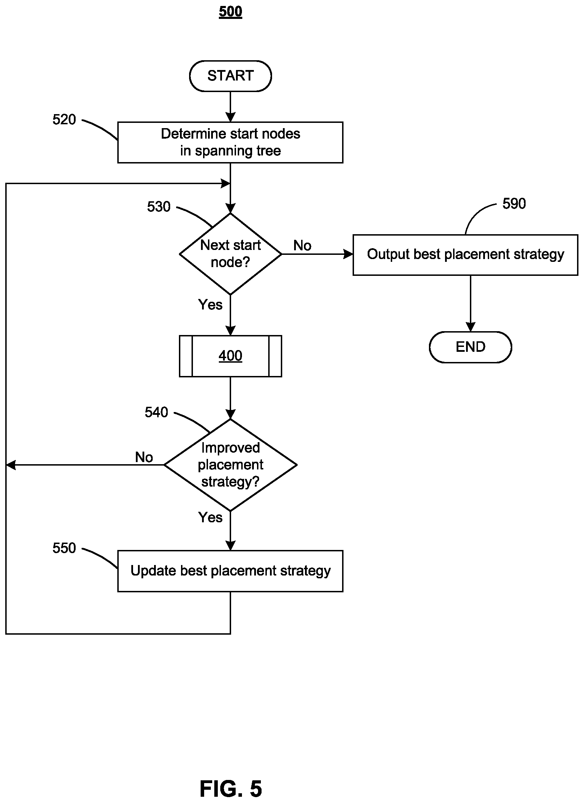

FIG. 5 illustrates a process 500 for determining an optimal placement of measurement devices for observability of a target system 140 (e.g., power network), according to an embodiment. Process 500 may be implemented by software 112 on management system 110, for example, within analysis and control module 330 of software 112. While process 500 is illustrated with a certain arrangement and ordering of subprocesses, process 500 may be implemented with fewer, more, or different subprocesses and a different arrangement and/or ordering of subprocesses. In addition, it should be understood that any subprocess, which does not depend on the completion of another subprocess, may be executed before, after, or in parallel with that other independent subprocess, even if the subprocesses are described or illustrated in a particular order.

At a high level, process 500 iteratively traverses a single spanning tree of the graph of target system 140. In each iteration, a different start node is selected than the start node that is selected in any other iteration, and a traversal of the spanning tree is performed starting from the selected start node. The traversal of the spanning tree may be performed by process 400 as a subprocess to process 500.

Subprocess 520 may determine a plurality of start nodes in the spanning tree. The selection of the start nodes may be performed in the same or similar manner as described above with respect to subprocess 420. For example, subprocess 520 may prioritize non-leaf nodes with the most direct connections, and in an embodiment, which are incident to a leaf node. Additionally or alternatively, subprocess 520 may prioritize diversity in location (e.g., select at least one start node from each of a plurality of segments of the spanning tree) and/or other attributes of the nodes. Subprocess 520 may select a predefined number of the highest priority nodes as start nodes, select all nodes satisfying one or more prioritization criteria as start nodes, or the like.

Subprocess 530 may determine whether or not there is another start node to be considered. In particular, subprocess 530 may iterate through each start node that was determined in subprocess 520. When another start node remains to be considered (i.e., "Yes" in subprocess 530), process 500 may execute an iteration of process 400 to generate a candidate placement strategy, and then proceed to subprocess 540. Otherwise, when no more start nodes remain to be considered (i.e., "No" in subprocess 530), process 500 may proceed to subprocess 590.

Subprocess 540 may determine whether or not the candidate placement strategy, generated by process 400, represents an improvement over the current best candidate placement strategy. In the first iteration of subprocess 540, the candidate placement strategy will always be an improvement, since there will be no other candidate placement strategy. In subsequent iterations of subprocess 540, the candidate placement strategy may be compared to the current best candidate placement strategy to determine which is best, relative to each other. In an embodiment, the candidate placement strategy, having a minimum number of measurement devices, is selected as the best placement strategy. In other words, when the newest candidate placement strategy, generated by process 400, has a fewer number of measurement devices than the current best candidate placement strategy, the newest candidate placement strategy is selected, and when the newest candidate placement strategy has a greater number of measurement devices than the current best candidate placement strategy, the current best candidate placement strategy is selected. In the event that both the newest candidate placement strategy and the current best candidate placement strategy have the same number of measurement devices, either the newest candidate placement strategy may always be selected, the current best candidate placement strategy may always be selected, one of the newest candidate placement strategy and the current best candidate placement strategy may be selected randomly, or one of the newest candidate placement strategy and the current best candidate placement strategy may be selected based on one or more other criteria, such as lowest cost to install the measurement devices, least geographically diverse placements, most geographically diverse placements, and/or the like. When determining that the newest candidate placement strategy represents an improvement over the current best placement strategy (i.e., "Yes" in subprocess 540), process 500 may proceed to subprocess 550. Otherwise, when determining that the newest candidate placement strategy does not represent an improvement over the current best placement strategy (i.e., "No" in subprocess 540), process 500 may return to subprocess 530.

Subprocess 550 may update the best candidate placement strategy with the newest candidate placement strategy that was generated by process 400. For example, process 500 may maintain a single candidate placement strategy as the best candidate placement strategy, and replace that single candidate placement strategy whenever a better candidate placement strategy is determined. Subprocess 590 may output the current and final best candidate placement strategy. In an embodiment that executes a plurality of iterations of process 500, as described elsewhere herein, the output placement strategy represents one candidate placement strategy, which may or may not be ultimately selected as a final and optimal placement strategy. Otherwise, in an embodiment that executes only a single iteration of process 500, the output placement strategy may represent the final and optimal placement strategy.

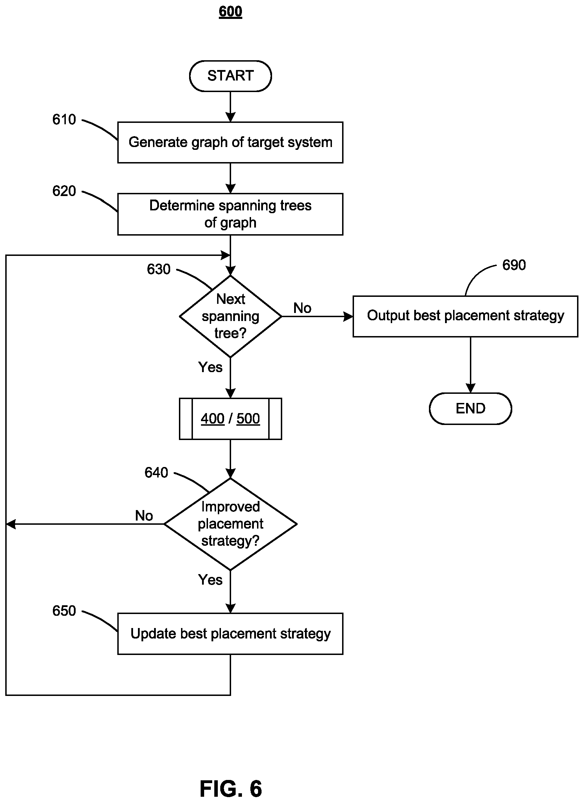

FIG. 6 illustrates a process 600 for determining an optimal placement of measurement devices for observability of a target system 140 (e.g., power network), according to an embodiment. Process 600 may be implemented by software 112 on management system 110, for example, within analysis and control module 330 of software 112. While process 600 is illustrated with a certain arrangement and ordering of subprocesses, process 600 may be implemented with fewer, more, or different subprocesses and a different arrangement and/or ordering of subprocesses. In addition, it should be understood that any subprocess, which does not depend on the completion of another subprocess, may be executed before, after, or in parallel with that other independent subprocess, even if the subprocesses are described or illustrated in a particular order.

At a high level, process 600 iteratively traverses a plurality of spanning trees of the same graph of target system 140. In each iteration, a different spanning tree is selected or otherwise identified than the spanning tree that is identified in any other iteration, and at least one traversal of the spanning tree is performed by process 400 or 500 as a subprocess of process 600.

Subprocess 610 may generate a graph of target system 140. The graph may be represented as a data structure comprising a plurality of nodes and one or more edges connecting pairs of nodes to each other. In an embodiment in which target system 140 is a power network, the nodes may represent buses, and the edges may represent electrical lines connecting the buses.

Subprocess 620 may determine a plurality of spanning trees of the graph. As described elsewhere herein, each spanning tree may comprise all of the nodes and at least a subset of the edges in the graph of target system 140 (e.g., one less edge than the number of nodes). It should be understood that each of the plurality of spanning trees is different than any other one of the plurality of spanning trees. The spanning trees may be generated using any suitable pathfinding algorithm, and different spanning trees may be generated using the same pathfinding algorithm (e.g., with different algorithmic parameters) or different pathfinding algorithms. Subprocess 620 may determine up to a predefined number of spanning trees, all possible spanning trees of the graph, or the like.

As one example of a pathfinding algorithm, the spanning tree is generated by sequentially selecting an edge from a list of edges and placing the edge in a bin. If one of the nodes at the end of the selected edge is incident (i.e., directly connected) to any edge in any bin, that node is placed into that bin. If both node at the end of the selected edge are in the same bin, the selected edge is discarded, since it would form a loop. If one of the nodes of the selected edge belongs to one bin and the other node of the selected edge belongs to another bin, the two bins are combined into one bin with the selected edge. If both of the nodes of the selected edge do not belong to any bin, a new bin is created with the selected edge. This procedure is repeated for each edge in the graph, until the list of edges is exhausted, at which point the procedure is terminated. If, upon termination, only a single bin exists with all of the edges, the bin defines the spanning tree. Otherwise, if, upon termination, multiple bins exist, the graph contains islands (i.e., subgraphs that are disconnected from each other within the original graph). In this case, each island may be processed as a separate graph in a separate iteration of process 600.

Subprocess 630 may determine whether or not there is another spanning tree to be considered. In particular, subprocess 630 may iterate through each spanning tree that was determined in subprocess 620. When another spanning tree remains to be considered (i.e., "Yes" in subprocess 630), process 600 may execute an iteration of either process 400 or 500 to generate a candidate placement strategy, and then proceed to subprocess 640. Otherwise, when no more spanning trees remain to be considered (i.e., "No" in subprocess 630), process 600 may proceed to subprocess 690.

Subprocess 640 may determine whether or not the candidate placement strategy, generated by either process 400 or 500, represents an improvement over the current best candidate placement strategy. In the first iteration of subprocess 640, the candidate placement strategy will always be an improvement, since there will be no other candidate placement strategy. In subsequent iterations of subprocess 640, the candidate placement strategy may be compared to the current best candidate placement strategy to determine which is best, relative to each other. In an embodiment, the candidate placement strategy, having a minimum number of measurement devices, is selected as the best placement strategy. In other words, when the newest candidate placement strategy, generated by either process 400 or 500, has a fewer number of measurement devices than the current best candidate placement strategy, the newest candidate placement strategy is selected, and when the newest candidate placement strategy has a greater number of measurement devices than the current best candidate placement strategy, the current best candidate placement strategy is selected. In the event that both the newest candidate placement strategy and the current best candidate placement strategy have the same number of measurement devices, either the newest candidate placement strategy may always be selected, the current best candidate placement strategy may always be selected, one of the newest candidate placement strategy and the current best candidate placement strategy may be selected randomly, or one of the newest candidate placement strategy and the current best candidate placement strategy may be selected based on one or more other criteria, such as lowest cost to install the measurement devices, least geographically diverse placements, most geographically diverse placements, and/or the like. When determining that the newest candidate placement strategy represents an improvement over the current best placement strategy (i.e., "Yes" in subprocess 640), process 600 may proceed to subprocess 650. Otherwise, when determining that the newest candidate placement strategy does not represent an improvement over the current best placement strategy (i.e., "No" in subprocess 640), process 600 may return to subprocess 630.

Subprocess 650 may update the best candidate placement strategy with the newest candidate placement strategy that was generated by either process 400 or 500. For example, process 600 may maintain a single candidate placement strategy as the best candidate placement strategy, and replace that single candidate placement strategy whenever a better candidate placement strategy is determined.

Subprocess 690 may output the current and final best candidate placement strategy as the optimal placement strategy. In an embodiment in which process 600 implements process 400, in each of a plurality of outer iterations, a different spanning tree is traversed, to generate a plurality of candidate placement strategies, and the optimal placement strategy (e.g., the candidate placement strategy having the minimum number of measurement devices) is selected from this plurality of candidate placement strategies. In an embodiment in which process 600 implements process 500, in each of a plurality of outer iterations, a different spanning tree is identified, and in each of a plurality of inner iterations, that identified spanning tree is traversed starting from a different start node. In this case, the optimal placement strategy (e.g., the candidate placement strategy having the minimum number of measurement devices) is selected from among all of the candidate placement strategies generated by the inner iterations of the outer iterations.

Advantageously, each of the embodiments, described above, guarantees a solution, even for very large target systems 140. This is in contrast to classical optimization techniques, which cannot guarantee convergence for very large power networks, such as those with three-hundred or more buses. In addition, embodiments of process 600, which implement process 400 and preferably process 500, produce optimal solutions that are the same as or close to the solutions produced by classical optimization techniques, without the complexity of classical optimization techniques. In other words, disclosed embodiments provide a computationally inexpensive and infinitely scalable approach, which approximates classical optimization techniques and guarantees convergence for even very large power networks (e.g., three-hundred or more nodes).

### 5. Example Operation

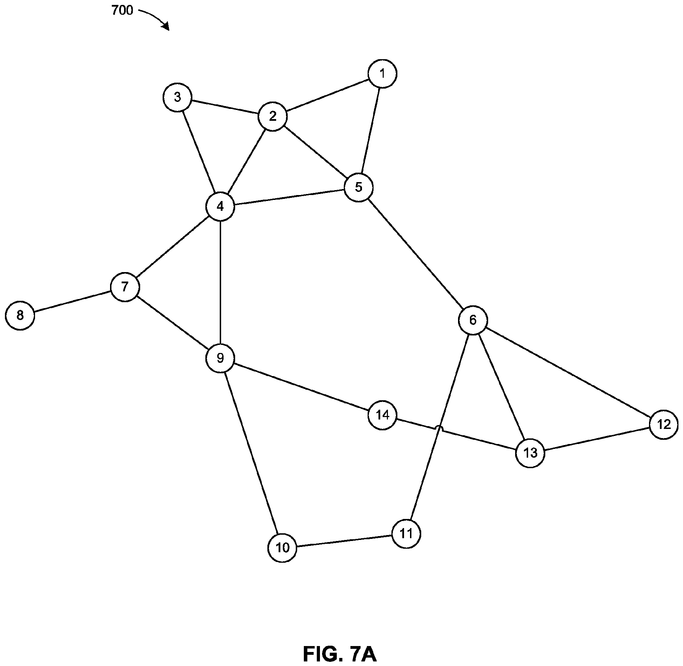

FIG. 7A illustrates a graph 700 of a target system 140, such as a power network, according to an example. In this example, graph 700 comprises fourteen nodes, numbered 1 through 14, representing an IEEE fourteen-bus system. Each node is connected to at least one other node by an edge, with each node representing a bus and each edge representing an electrical line. It should be understood that graph 700 is a simple example for the purposes of explication only. In reality, graph 700 may be much larger, potentially including three-hundred or more nodes.

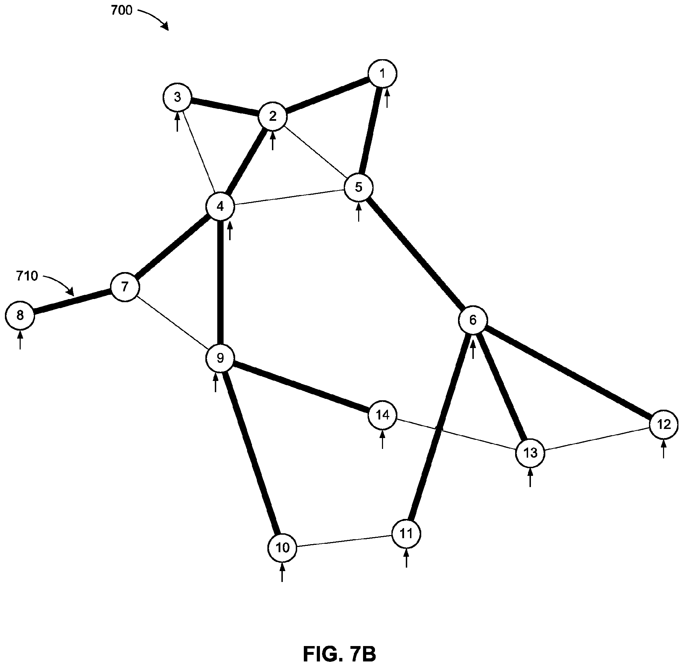

FIG. 7B illustrates a spanning tree 710 of graph 700 of a target system 140, such as a power network, according to an example. In this example, spanning tree 710 comprises all of the nodes in graph 700 and consists of only a subset of the edges in graph 700 (i.e., thirteen edges in a fourteen-bus system). The subset of edges in spanning tree 710 ensures that every node is connected, either directly or indirectly, to every other node in graph 700, so as to form a tree. Notably, in spanning tree 710, Nodes 3, 8, and 10-14 are leaf nodes, and the remainder of the nodes are non-leaf nodes. In addition, each node with an associated vertical arrow (i.e., Nodes 1-6 and 8-14) injects power (positive or negative) into the power network, and each node without an associated vertical arrow (i.e., Node 7) is a zero-injection node. It should be understood that spanning tree 710 is just one example of a spanning tree for graph 700, and that it is possible to generate a number of different spanning trees from graph 700.

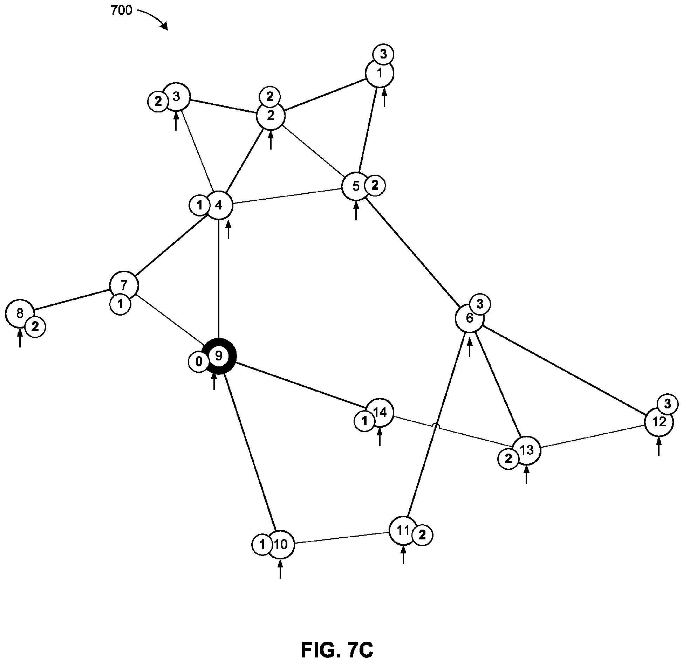

FIG. 7C illustrates the distance values of the nodes in graph 700 of a target system 140, according to an example. In the illustrated example, it is assumed that a measurement device has been placed at Node 9 in subprocess 450, as represented by the bold outline, and that no measurement devices have been placed at any other node. The overlaid offset value on each node indicates the distance value of that node after execution of subprocess 460. In particular, the distance value for Node 9 is the first value (e.g., zero) per Rule (1) of the distance rules, the distance values for Nodes 4, 7, 10, and 14 are the second value (e.g., one) per Rule (2) of the distance rules, the distance values for Nodes 2, 3, 5, 8, 11, and 13 are the third value (e.g., two) per Rule (3) of the distance rules, and the distance values for Nodes 1, 6, and 12 are the fourth value (e.g., three) per Rule (4) of the distance rules.

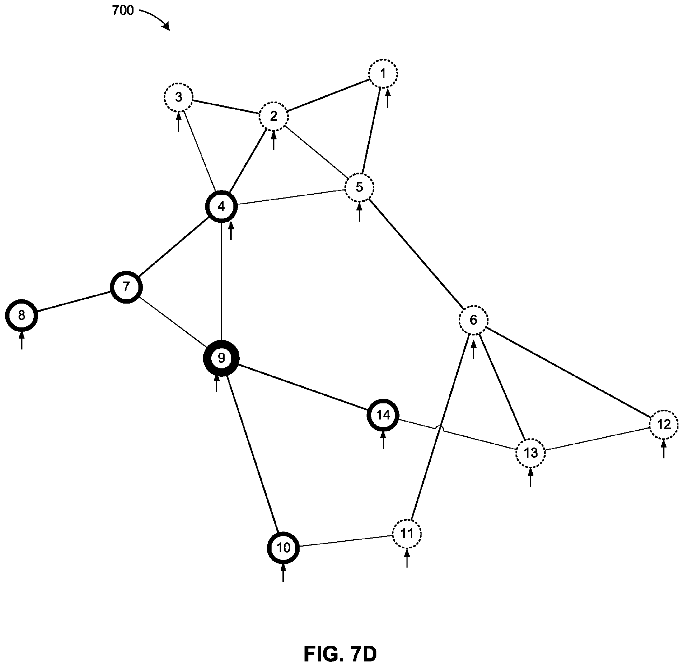

FIG. 7D illustrates the observability statuses of the nodes in graph 700 of a target system 140, according to an example. In the illustrated example, it is assumed that a measurement device has been placed at Node 9 in subprocess 450, and that no measurement devices have been placed at any other node. The observability status of each node, after execution of subprocess 460, is depicted with a bold node outline representing a node that is observable and a non-bold node outline representing a node that is non-observable. In particular, the observability status for Node 9 is observable per Rule (1) of the observability rules, the observability statuses for Nodes 4, 7, 10, and 14 are observable per Rule (2) of the observability rules (the observability status for Node 7 would also be observable per Rule (4) of the observability rules), the observability status of Node 8 is observable per Rule (3) of the observability rules, and the observability statuses of Nodes 1-3, 5, 6, and 11-13 are non-observable per Rule (5) of the observability rules.

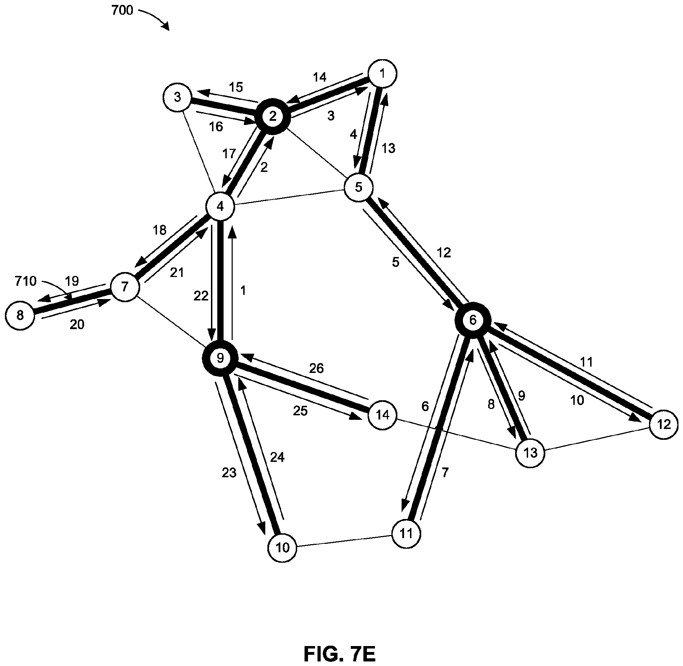

FIG. 7E illustrates an example traversal of spanning tree 710 of graph 700 of a target system 140, according to an embodiment of process 400. In this example, Node 9 was determined to be the start node in subprocess 420, and the placement strategy (i.e., Nodes 2, 6, and 9) is depicted by bold node outlines. The traversal started at Node 9 (with placement of a measurement device at Node 9), and then proceeded to Node 4, to Node 2 (with placement of a measurement device at Node 2), to Node 1, to Node 5, to Node 6 (with placement of a measurement device at Node 6), to Node 11, back to Node 6, to Node 13, back to Node 6, to Node 12, back to Node 6, back to Node 5, back to Node 1, back to Node 2, to Node 3, back to Node 2, back to Node 4, to Node 7 to Node 8, back to Node 7, back to Node 4, back to Node 9, to Node 10, back to Node 9, to Node 14, and back to Node 9, at which point the traversal ended. Notably, the result is an optimal placement strategy that minimizes the number of measurement devices (i.e., three) in target system 140 while ensuring observability of all nodes in target system 140. In other words, there is no way to fully observe the state of target system 140 with fewer than three measurement devices.

### 6. Example Application

Disclosed embodiments avoid the curse of dimensionality and guarantee convergence, even for very large systems. Conceptually, measurement devices are placed sequentially at the nodes in a target system 140, while ensuring that, at each instant, the nodes between successive placements are observable. Spanning trees are used to define the sequence in which the nodes are traversed and ensure that the placement process will have a defined "directed walk" through the nodes. In an embodiment, a new measurement device is effectively placed three nodes away from the most recently placed measurement device. A placement strategy that achieves observability of the spanning tree will simultaneously achieve observability of the original graph from which the spanning tree was derived.

In practice, disclosed embodiments guarantee an optimal placement strategy of measurement devices, such as phasor measurement units for measuring voltage and current, across a geographically dispersed power network of any size, such that the voltage at each bus is observable, in dramatically less computational time than optimization techniques. An optimal placement strategy may be defined as a placement strategy that consists of the minimum number of measurement devices required for observability of target system 140. Advantageously, disclosed embodiments are capable of operating with an existing placement of measurement devices.

Notably, during experimentation, a state-of-the-art Tabu search for a power network with three-hundred nodes was unable to produce an optimal placement strategy even after several hours of computation. In contrast, disclosed embodiments were able to produce optimal placement strategies within minutes for power networks with thousands of nodes. The optimal placement strategy, output by disclosed embodiments, may not always be the most optimal placement strategy, but it will always be close to the most optimal placement strategy and can be made more accurate by increasing the number of iterations (e.g., the number of spanning trees considered in the outer iterations of process 600 and/or the number of start nodes considered in the inner iterations of process 500).

The results of a number of experiments using the disclosed embodiments are depicted below:

| System | No. Nodes (buses) | No. Edges (branches) | No. Measurement Devices |
|---|---|---|---|
| IEEE14 | 14 | 20 | 3 |
| IEEE57 | 57 | 80 | 17 |
| IEEE118 | 118 | 186 | 36 |
| IEEE300 | 300 | 411 | 94 |
| Polish Grid | 2,383 | 2,896 | 777 |
| 9241-bus | 9,241 | 16,049 | 2,671 |

Disclosed embodiments may be used to determine the optimal placement of measurement devices within a target system 140. For example, an operator may utilize disclosed embodiments to determine the optimal placement strategy of measurement devices, such as phasor measurement units, within a power network (e.g., electrical grid), with or without existing placements. The operator may then physically install the measurement devices within the power network, according to the determined placement strategy. In other words, the operator may install a measurement device at each bus that is indicated in the placement strategy that was output by a disclosed embodiment. These measurement devices, once installed, may transmit real-time voltage and current measurements to a management system 110, at very high sampling rates, for real-time analysis and control of the power network. From these measurements, analysis and control module 330 may determine the entire state of the power network without having to resort to estimation, and perform control accordingly.

As an alternative use case, disclosed embodiments may generate a placement strategy for input into a linear state estimator (e.g., of analysis and control module 330). In particular, the placement strategy may be used to determine the required locations of measurement devices for effective real-time linear state estimation for real-time control of a target system 140, such as a power network.

The above description of the disclosed embodiments is provided to enable any person skilled in the art to make or use the invention. Various modifications to these embodiments will be readily apparent to those skilled in the art, and the general principles described herein can be applied to other embodiments without departing from the spirit or scope of the invention. Thus, it is to be understood that the description and drawings presented herein represent a presently preferred embodiment of the invention and are therefore representative of the subject matter which is broadly contemplated by the present invention. It is further understood that the scope of the present invention fully encompasses other embodiments that may become obvious to those skilled in the art and that the scope of the present invention is accordingly not limited.

As used herein, the terms "comprising," "comprise," and "comprises" are open-ended. For instance, "A comprises B" means that A may include either: (i) only B; or (ii) B in combination with one or a plurality, and potentially any number, of other components. In contrast, the terms "consisting of," "consist of," and "consists of" are closed-ended. For instance, "A consists of B" means that A only includes B with no other component in the same context.

Combinations, described herein, such as "at least one of A, B, or C," "one or more of A, B, or C," "at least one of A, B, and C," "one or more of A, B, and C," and "A, B, C, or any combination thereof' include any combination of A, B, and/or C, and may include multiples of A, multiples of B, or multiples of C. Specifically, combinations such as "at least one of A, B, or C," "one or more of A, B, or C," "at least one of A, B, and C," "one or more of A, B, and C," and "A, B, C, or any combination thereof' may be A only, B only, C only, A and B, A and C, B and C, or A and B and C, and any such combination may contain one or more members of its constituents A, B, and/or C. For example, a combination of A and B may comprise one A and multiple B's, multiple A's and one B, or multiple A's and multiple B's.

## Claims

1. A method comprising using at least one hardware processor to determine an optimal placement strategy, for measurement devices in a power network, that provides observability of a plurality of nodes in the power network, by:
in each of one or more outer iterations,
identifying a spanning tree of the power network, wherein the spanning tree comprises all of the plurality of nodes in the power network and one or more edges that each represents a connection between a pair of the plurality of nodes,
in each of one or more inner iterations, generating a candidate placement strategy by
selecting a start node from the plurality of nodes,
traversing the spanning tree, starting from the start node, such that each of the plurality of nodes is visited at least once and a distance value is maintained for each of the plurality of nodes, wherein the distance value for each of the plurality of nodes represents a distance between that node and a measurement device, and
when visiting each of the plurality of nodes for a first time,
determining whether or not to place the measurement device at the node based on the distance value for the node, and
when determining to place the measurement device at the node, updating the candidate placement strategy to include a placement of the measurement device at the node, and updating the distance values for the plurality of nodes; and
determine the optimal placement strategy from one or more candidate placement strategies generated in the one or more inner iterations of the one or more outer iterations.

2. The method of Claim 1, wherein the measurement devices comprise phasor measurement devices.

3. The method of any one of the preceding claims, wherein each of the measurement devices is configured to measure at least one parameter, including one or both of voltage or current, at one of the plurality of nodes in the power network, and wherein each of the measurement devices is configured to transmit the at least one parameter to a control system over at least one communication network.

4. The method of any one of the preceding claims, wherein the one or more inner iterations are a plurality of inner iterations, such that a plurality of candidate placement strategies are generated across the plurality of inner iterations, and wherein, in each of the plurality of inner iterations, a different start node is selected in that inner iteration than the start node that is selected in any other ones of the plurality of inner iterations, and/or
wherein the one or more outer iterations are a plurality of outer iterations, such that a plurality of candidate placement strategies are generated across the plurality of outer iterations, and wherein, in each of the plurality of outer iterations, a different spanning tree is identified in that outer iteration than the spanning tree that is identified in any other ones of the plurality of outer iterations.

5. The method of Claim 4, further comprising using the at least one hardware processor to select one of the plurality of candidate placement strategies, having a minimum number of the measurement devices, as the optimal placement strategy.

6. The method of any one of the preceding claims, wherein generating the candidate placement strategy further comprises:
while traversing the spanning tree, maintaining an observability status for each of the plurality of nodes; and
when determining to place the measurement device at one of the plurality of nodes, updating the observability statuses for all of the plurality of nodes, and preferably
wherein updating the observability statuses for all of the plurality of nodes comprises, for each of the plurality of nodes:
when the measurement device has been placed at the node, set the observability status for the node to observable;
when the node is directly connected to another one of the plurality of nodes at which the measurement device has been placed, set the observability status for the node to observable;
when the node is directly connected to a zero-injection node, from among the plurality of nodes, and all other ones of the plurality of nodes connected to the zero-injection node are observable, set the observability status for the node to observable;
when the node is a zero-injection node and all other ones of the plurality of nodes connected to the node have an observability status of observable, set the observability status for the node to observable; and
otherwise, set the observability status for the node to non-observable.

7. The method of any one of the preceding claims, wherein updating the distance values for all of the plurality of nodes comprises, for each of the plurality of nodes:
when the measurement device has been placed at the node, set the distance value for the node to a first value;
otherwise, when the node is directly connected to another one of the plurality of nodes at which the measurement device has been placed, set the distance value for the node to a second value that represents a greater distance than the first value;
otherwise, when the node is directly connected to another one of the plurality of nodes that has a distance value that is set to the second value, set the distance value for the node to a third value that represents a greater distance than the second value; and
otherwise, when the node is directly connected to another one of the plurality of nodes that has a distance value that is set to the third value, set the distance value for the node to a fourth value that represents a greater distance than the third value.

8. The method of Claim 7, wherein determining whether or not to place the measurement device at the node based on the distance value for the node comprises:
when the distance value for the node is less than the fourth value, determine not to place the measurement device at the node; and
when the distance value for the node is equal to or greater than the fourth value, determine to place the measurement device at the node.

9. The method of any one of the preceding claims, wherein generating the candidate placement strategy further comprises:
when visiting each of the plurality of nodes for the first time, flagging the node as having been visited; and
when visiting each of the plurality of nodes,
determining whether or not the node has already been visited based on whether or not the node has been flagged as having been visited, and
when determining that the node has already been visited,
when the node is directly connected to an unvisited one of the plurality of nodes that has not been flagged as having been visited, visit the unvisited node next,
when the node is not directly connected to any unvisited ones of the plurality of nodes that have not been flagged as having been visited and the node is not the start node, backtracking to one of the plurality of nodes that was visited before the node, and
when the node is not directly connected to any unvisited ones of the plurality of nodes that have not been flagged as having been visited and the node is the start node, ending the traversal of the spanning tree.

10. The method of either Claim 9, wherein generating a candidate placement strategy further comprises ending the traversal of the spanning tree when all of the plurality of nodes have been flagged as having been visited.

11. The method of any one of the preceding claims, wherein generating the candidate placement strategy further comprises, when visiting each of the plurality of nodes:
determining whether or not the node is a leaf node; and
when determining that the node is a leaf node, backtracking to one of the plurality of nodes that was visited before the node.

12. The method of any one of the preceding claims, further comprising using the at least one hardware processor to, prior to determining the optimal placement strategy, receive an existing placement of one or more existing measurement devices at one or more of the plurality of nodes, wherein each candidate placement strategy is initialized to include the existing placement of the one or more existing measurement devices, and/or
wherein determining the optimal placement strategy from the one or more candidate placement strategies comprises selecting one of the one or more candidate placement strategies, having a minimum number of the measurement devices, as the optimal placement strategy.

13. The method of any one of the preceding claims, further comprising using the at least one hardware processor to transmit the optimal placement strategy to a human-to-machine interface, and/or
further comprising installing physical measurement devices at locations within the power network that correspond to a subset of the plurality of nodes at which measurement devices have been placed according to the optimal placement strategy.

14. A system comprising:
at least one hardware processor; and
software that is configured to, when executed by the at least one hardware processor, perform the method of any one of the preceding claims.

15. A non-transitory computer-readable medium having instructions stored therein, wherein the instructions, when executed by a processor, cause the processor to perform the method of any one of Claims 1 through 13.
